(19) Europäisches Patentamt

European Patent Office

Office européen des brevets

(11) **EP 1 612 766 A1**

(12) **EUROPEAN PATENT APPLICATION**

(43) Date of publication:
**04.01.2006 Bulletin 2006/01**

(51) Int Cl.:
***G09G 3/32*** (2006.01)

(21) Application number: **05105799.0**

(22) Date of filing: **29.06.2005**

(84) Designated Contracting States:
**AT BE BG CH CY CZ DE DK EE ES FI FR GB GR
HU IE IS IT LI LT LU MC NL PL PT RO SE SI SK TR**
Designated Extension States:
**AL BA HR LV MK YU**

(30) Priority: **29.06.2004 KR 2004049718**

(71) Applicant: **Samsung SDI Co., Ltd.
Suwon-si
Gyeonggi-do (KR)**

(72) Inventor: **KIM, Keum Nam,
Legal IP Team, Samsung SDI Co. Ltd.
Kyunggi-do (KR)**

(74) Representative: **Hengelhaupt, Jürgen
Anwaltskanzlei
Gulde Hengelhaupt Ziebig & Schneider
Wallstrasse 58/59
10179 Berlin (DE)**

(54) **Light emitting diode display circuit with voltage drop compensation**

(57) A light emitting display having a pixel circuit for compensating driving voltage variation between pixels due to voltage drop in the voltage supply line. The light emitting display includes pixels, data lines extending in a first direction, through which a data signal is supplied to the pixels, scan lines extending in a second direction crossing the first direction, through which a selection signal is supplied to the pixels, a first power source line supplying driving voltage to the pixels, and a second pow- er source line along the first direction supplying a com- pensating voltage to the pixels. The compensating volt- age compensates for the drop of driving voltage across pixels that can cause non-uniformity in brightness of the display.

FIG. 7

**Description**

<u>CROSS-REFERENCE TO RELATED APPLICATION</u>

This application claims priority to and the benefit of Korean Patent Application No. 2004-49718, filed on June 29, 2004, in the Korean Intellectual Property Office, the entire content of which is incorporated herein by reference.

**BACKGROUND**

**1. Field of the Invention**

The present invention relates to a light emitting display, and more particularly, to a light emitting display having an improved layout structure for compensating voltage drop difference between pixels.

**2. Discussion of Related Art**

Generally, an organic light emitting display uses an organic light emitting diode made of fluorescent or electrically excitable phosphorous organic compounds. The organic light emitting diode emits light based on the supplied voltage or current. Further, the organic light emitting diode has a laminated structure including an anode, an organic thin film, and a cathode. The organic thin film is made of organic compounds. Further, the organic thin film has a multi-layer structure where a hole injecting layer and an electron injecting layer are placed on opposite sides of a light emitting layer to enhance injection characteristics for an electron and a hole. Also, the organic thin film emission can selectively include an electron transporting layer, a hole transporting layer, and a hole blocking layer to enhance characteristics of an organic emission cell.

As for a method of driving the organic light emitting display, there is a passive matrix driving type method, and an active matrix driving type method. In the case of the passive matrix driving type method, a pixel coupled to a scan line corresponding to a predetermined row receives current for a selected time and emits light having brightness corresponding to the received current. In the case of the active matrix driving type method, voltage to represent a predetermined gradation is stored in a capacitor, and the stored voltage is applied to a pixel for the whole frame time. Such an active matrix driving type method is classified into a voltage programming method and a current programming method according to applied signals for storing the voltage in the capacitor.

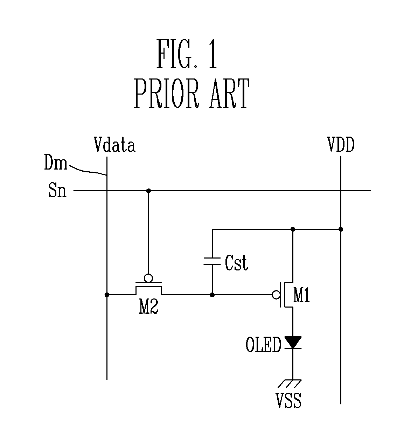

FIG. 1 is a circuit diagram of a pixel circuit provided in a conventional organic light emitting display. In FIG. 1, the pixel circuit indicates one among nxm pixel circuits, which is coupled to an $m^{th}$ data line Dm and an $n^{th}$ scan line Sn. The pixel circuit includes a driving transistor M1, a switching transistor M2, and a capacitor Cst to drive an organic light emitting diode OLED. The driving transistor M1 is coupled between a pixel power voltage line VDD and the organic light emitting diode OLED. The switching transistor M2 is coupled between the data line Dm and a gate of the driving transistor M1, and is turned on/off in response to a selection signal transmitted to the scan line Sn. The capacitor Cst is coupled between the pixel power voltage line VDD and the gate of the driving transistor M1.

The conventional pixel circuit operates as follows. First, when the selection signal is transmitted to the scan line Sn, the switching transistor M2 is turned on. In this state, a data voltage Vdata applied to the data line Dm is applied to one terminal of the capacitor Cst through the switching transistor M2, and the capacitor Cst stores voltage corresponding to voltage difference between the pixel power voltage line VDD and the data voltage Vdata. The driving transistor M1 is operated as a static current source by a predetermined voltage stored in the capacitor Cst, and supplies current to the organic light emitting diode OLED. At this time, the current flowing in the organic light emitting diode OLED is calculated by the following equation 1.

[equation 1]

$$I_{OLED} = \frac{\beta}{2}\left(Vgs - Vth\right)^2 = \frac{\beta}{2}\left(VDD - Vdata - Vth\right)^2$$

where $I_{OLED}$ is a current flowing in the organic light emitting diode OLED; Vgs is a voltage applied between the gate and a source of the driving transistor M1; Vth is the threshold voltage of the driving transistor M1; Vdata is the data voltage; and $\beta$ is a coefficient.

The conventional active matrix type organic light emitting display generally employs a thin film transistor (TFT) as a switching device to control each pixel because it is easily fabricated and excellent in characteristics. However, in the conventional organic light emitting display, variation between the threshold voltages Vth of the TFTs occurs due to non-uniformity of the fabricating process. Thus, the intensity of current applied to the organic light emitting diode varies, thereby causing problems with short-range (SR) uniformity.

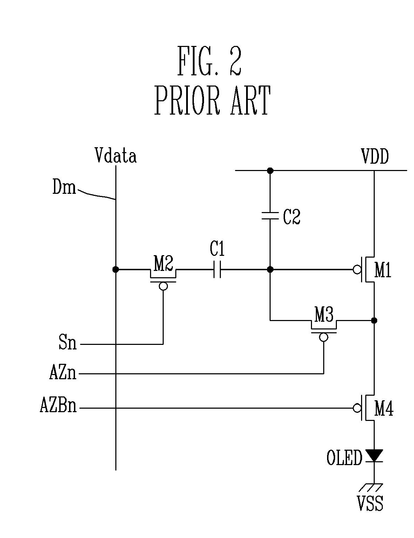

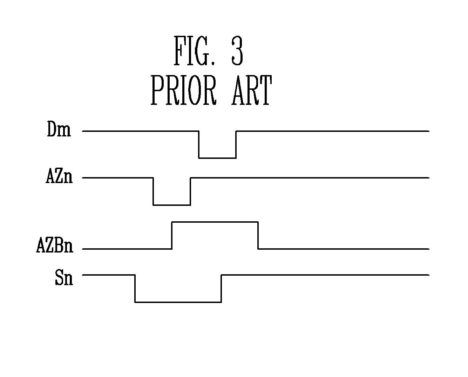

FIG. 2 is a circuit diagram of another pixel circuit available in conventional organic light emitting displays. This circuit is designed to solve the foregoing problems of non-uniformity in brightness due to the variation among the threshold voltages of the driving transistors. FIG. 3 illustrates waveforms for driving the pixel circuit of FIG. 2. The pixel circuit includes a driving transistor M1, a first switching transistor M2, a second switching transistor M3, a third switching transistor M4, a first capacitor C1, and a second capacitor C2 in order to drive an organic light emitting diode OLED. The driving transistor M1 is coupled between a pixel power voltage line VDD and a third switching transistor M4. The first switching transistor M2 is coupled between a data line Dm and the first capacitor C1 and turned on/off in response to a switching signal applied to a scan line Sn. The second switching transistor M3 is coupled between a drain electrode and a gate electrode of the driving transistor M1. The third switching transistor M4 is coupled between the drain electrode of the driving transistor M1 and the organic light emitting diode OLED. The first capacitor C1 is coupled between the first switching transistor M2 and the gate electrode of the driving transistor M1. The second capacitor C2 is coupled between the pixel power voltage line VDD and the gate electrode of the driving transistor M1.

Referring to the driving waveforms of FIG. 3, the pixel circuit of FIG. 2 operates as follows. The first switching transistor M2 is turned on in response to a first control signal, having an enable level, and transmitted to the first scan line Sn and the second switching transistor M3 is turned on in response to a second control signal transmitted to a second scan line AZn. The driving transistor M1 is coupled like a diode and the first capacitor C1 is charged with a first voltage corresponding to difference between pixel voltage applied to the pixel power voltage line VDD and the data voltage Vdata. Then, the second switching transistor M3 is turned off in response to the second scan signal transmitted to the second scan line Azn having a disable level. As a result, a second voltage corresponding to difference between the pixel voltage applied to the pixel power voltage line VDD and the data voltage is charged in a serial circuit including the first capacitor C1 and the second capacitor C2 while the first switching transistor M2 remains turned on. Thereafter, the first switching transistor M2 is turned off in response to the first scan signal having the disable level and the third switching transistor M4 is tuned on in response to a third scan signal having an enable level and transmitted to a third scan line AZBn. As a result, the driving transistor M1 is used as a predetermined static current source to supply current to the organic light emitting diode OLED according to levels of the voltage stored in the second capacitor C2. The voltage between the gate and the source of the driving transistor M1 is calculated by the following equation 2.

[equation 2]

$$Vgs = Vth - \frac{C1}{C1 + C2}(VDD - Vdata)$$

where Vth is the threshold voltage of the driving transistor M1; Vdata is the data voltage; and VDD is the pixel voltage.

As seen in the pixel circuit of FIG. 2 and as shown in equation 2, the data voltage Vdata is divided by the first and second capacitors C1 and C2. However, with this arrangement, either the data voltage Vdata or the capacitance for the first capacitor C1 should be high in order to generate a sufficient Vgs in the absolute value.

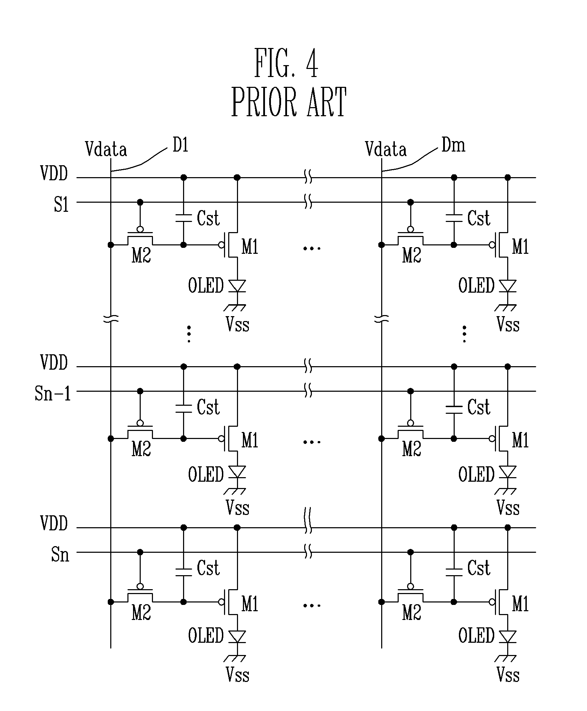

The pixel power voltage line VDD for supplying the pixel voltage to the pixel circuit can be arranged in a horizontal or vertical direction. However, in a case that the pixel power voltage line VDD is arranged in the horizontal direction as shown in FIG. 4, the load (impedance) increases as the number of transistors coupled to one horizontal pixel power voltage line VDD increases, thereby consuming a relatively large amount of current. Consequently, voltage drop occurs between a power supplying point of the first driving transistor and a power supplying point of the last driving transistor. For example, in the circuit of FIG. 4, the pixel voltage supplied to the pixel circuits on the right side of the figure is lower than that supplied to the pixel circuits on the left side. This will cause a problem in long-range uniformity because voltage delivered to a pixel by the power source line may vary depending on the design of the circuit and the location where the input of the pixel power voltage line VDD is coupled.

As described above, in a case that the current flows in the transistor while the data voltage Vdata is programmed, voltage drop occurs due to the internal resistance of the pixel power source lines VDD used for supplying the pixel voltage. The voltage drop increases in proportion to the amount of current flowing in the pixel power source line. Hence, even through the same data voltage Vdata is applied to the various pixel circuits, voltages applied to the gate electrodes of the driving transistors M1 are different according to the position of the pixel circuits with respect to the pixel power source line. Variation in the voltages applied to the driving transistors M1 causes the current flowing in the organic light emitting diode OLED not to be uniform, thereby making the brightness of OLED non-uniform.

## SUMMARY OF THE INVENTION

Accordingly, this invention provides a light emitting display that can compensate for the voltage drop difference between pixels, thereby making brightness uniform. This invention also provides a light emitting display, which can compensate for the difference between threshold voltages of driving transistors used in different pixel circuits, thereby making brightness uniform.

The present invention provides a light emitting display, in which voltage drop difference between pixels is compensated, and thus variation between the threshold voltages of driving transistors in a pixel circuit is compensated, thereby enhancing brightness uniformity. Further, the present invention provides a light emitting display, in which there is no substantial voltage drop between pixels, so that cross-talk due to voltage drop is prevented and the center of a screen is not darkened.

The foregoing and/or other aspects of the present invention are achieved by providing a light emitting display including a plurality of pixels, a plurality of data lines extending in a first direction through which a data signal is supplied to the plurality of pixels, a plurality of scan lines extending along a second direction intersecting the first direction through which a selection signal is supplied to the plurality of pixels, a first power source line through which first power voltage is supplied to the plurality of pixels, and a second power source line extending along the first direction through which a second power voltage is supplied to the plurality of pixels. Further, the second power voltage compensates for the voltage drop in the first power source line.

According to one embodiment of the invention, the pixel includes a driving transistor having a first electrode coupled to the first power source line and a second electrode coupled to a light emitting device, a first capacitor having a first electrode coupled to the first power source line, a second capacitor coupled between a gate of the driving transistor and a second electrode of the first capacitor, a first switching device coupled between the second electrode of the second capacitor and the gate of the driving transistor, a second switching device coupled between the second power source line and the second electrode of the first capacitor, and a third switching device coupled between the data line and the second electrode of the first capacitor.

According to another embodiment of the invention, the light emitting display further includes a fourth switching device coupled between the second electrode of the driving transistor and the light emitting device. Each of the first, second and fourth switching devices has a control electrode coupled to a first scan line, and the third switching device has a control electrode coupled to a second scan line. Further, the first and second switching devices include transistors of the same channel type, and the fourth switching device includes a transistor of a different channel type from the first and second switching devices. Also, the selection signal supplied through the first scan line is substantially equal to the selection signal supplied through the second scan line coupled to the pixels of a previous row.

In yet another embodiment of the invention, each of the first and second switching devices has a control electrode coupled to the first scan line, the third switching device has a control electrode coupled to the second scan line, and the fourth switching device has a control electrode coupled to a third scan line. Further, a third selection signal is supplied to the fourth switching device through the third scan line while first and second selection signals are supplied to the first through third switching devices. Also, the first, second, and fourth switching devices include transistors of the same channel type.

The first power source line may extend along the first direction or along the second direction. The second power source line may be used to individually supply the second power voltages to the plurality of pixels placed in a row selected by the selection signal. The second power voltage may be substantially equal to the first power voltage.

Other embodiments include a light emitting display including a data line extending in a first direction, first and second scan lines extending in a second direction intersected by the first direction through which first and second selection signals are transmitted, a first power source line extending in the first direction, a second power source line extending also in the first direction, a pixel coupled with the data line, the first scan line, the second scan line, the first power source line, and the second power source line, where the pixel includes a light emitting device, a driving transistor to supply a current corresponding to the voltage applied to its gate to the light emitting device, a first capacitor to store first voltage corresponding to the difference between a first power voltage flowing in the first power source line and a data voltage, a second capacitor to store a second voltage corresponding to difference between the threshold voltage of the driving transistor and the second power voltage flowing in the second power source line, a first switching device to control the driving transistor to have a diode-like connection in response to the first selection signal, a second switching device to supply the second power voltage to a first electrode of the first capacitor in response to the first selection signal, and a third switching device to supply the data voltage to the first electrode of the first capacitor in response to the second selection signal.

The light emitting display may further include a fourth switching device to transmit an output from the driving transistor to the light emitting device. For this, the fourth switching device has a control electrode coupled to the second scan line. Further, the fourth switching device has a control electrode coupled to an additional third scan line. In this case, a third selection signal is supplied to the fourth switching device through the third scan line while the first and second selection signals are supplied to the first through third switching devices.

## BRIEF DESCRIPTION OF THE DRAWINGS

FIG. 1 is a circuit diagram of a pixel circuit used in conventional organic light emitting displays.
FIG. 2 is a circuit diagram of another pixel circuit used in conventional organic light emitting displays.
FIG. 3 illustrates waveforms for driving the pixel circuit of FIG. 2.
FIG. 4 is a circuit diagram of a conventional organic light emitting display.
FIG. 5 is a layout of an organic light emitting display according to a first embodiment of the present invention.
FIG. 6 is a cross-sectional view of the organic light emitting display of FIG. 5 taken along line VI-VI.
FIG. 7 is a circuit diagram of the organic light emitting display of the first embodiment of the present invention.
FIG. 8 illustrates waveforms for driving the pixel circuits of FIG. 7.
FIG. 9 is a circuit diagram of an organic light emitting display according to a second embodiment of the present invention.

## DETAILED DESCRIPTION

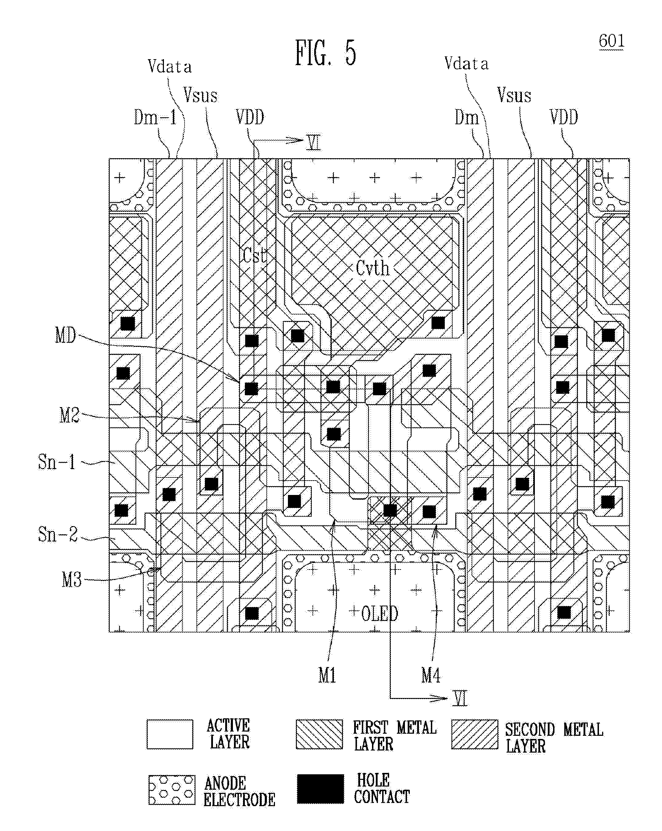

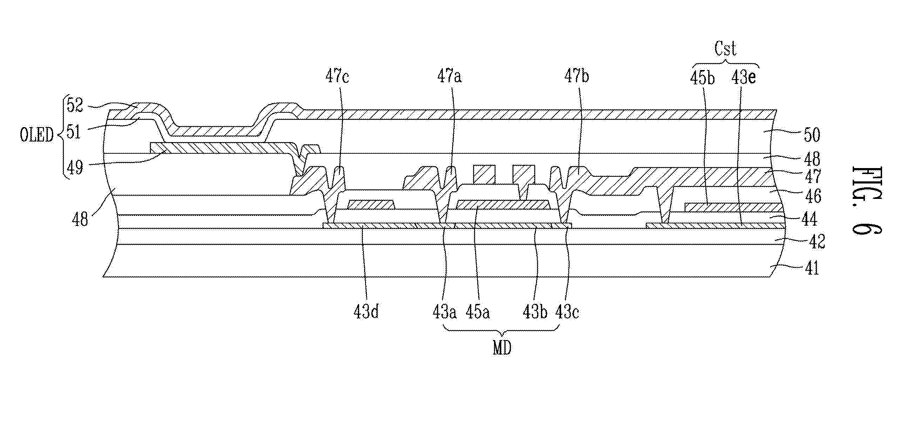

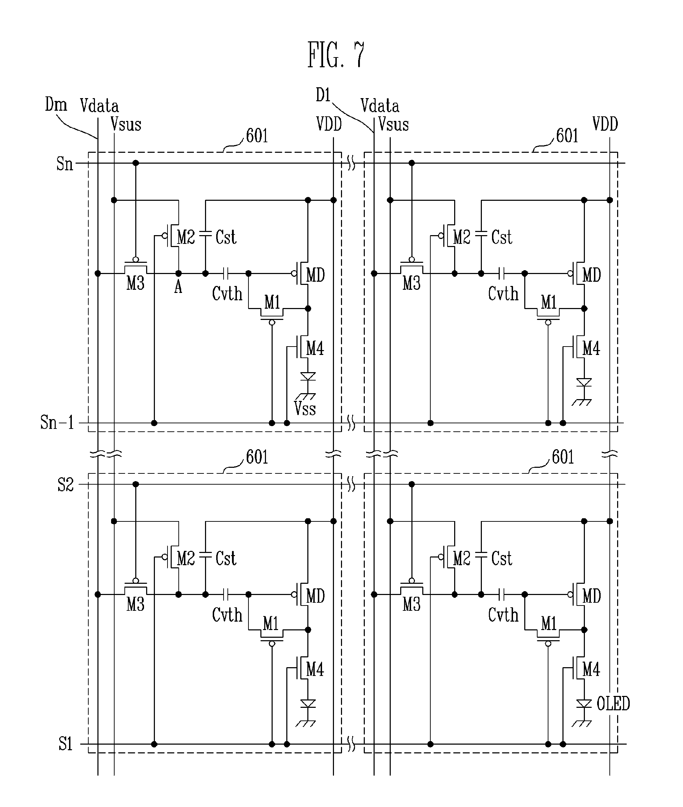

FIG. 5 is a layout of an organic light emitting display according to a first embodiment of the present invention, FIG. 6 is a cross-sectional view of the organic light emitting display of FIG. 5 taken along line VI-VI, and FIG. 7 is a circuit diagram of the organic light emitting display of the first embodiment of the present invention.
Referring to FIG. 5, a light emitting display according to the first embodiment of the present invention includes a plurality of pixel circuits 601. As shown in FIG. 7, each pixel circuit 601 includes five transistors and two capacitors. In the example shown in FIG. 5, a pixel circuit 601 coupled to the $(m-1)^{th}$ data line Dm-1 and the $(n-1)^{th}$ scan line Sn-1 is shown among nxm pixel circuits 601. The light emitting display includes pixel circuits 601 having a second power source line Vsus to compensate voltage drop between pixels. In more detail, the pixel circuit 601 of the light emitting display includes a driving transistor MD, a first capacitor Cst, a second capacitor Cvth, a first switching device M1, a second switching device M2, a third switching device M3, and a fourth switching device M4. The first through fourth switching devices M1, M2, M3, M4 are formed from thin film transistors or TFT. Particularly, the fourth switching device M4 is formed from a dual gate type thin film transistor. With this configuration, the pixel circuit 601 supplies a predetermined current to an organic light emitting diode OLED, causing the organic light emitting diode OLED to emit light.
Further, the pixel circuit 601 is coupled to the data line Dm-1, a first scan line Sn-1, a second scan line Sn-2, a first power source line VDD, and the second power source line Vsus. The data line Dm-1 indicates the $(m-1)^{th}$ data line, and the first and second scan lines Sn-1, Sn-2 indicate the $(n-1)^{th}$ and $(n-2)^{th}$ scan lines, respectively.
The data line Dm-1 extends in a first direction, and is coupled to a first electrode of the third switching device M3. The first direction corresponds to a vertical direction in FIG. 5.
The first scan line Sn-1 extends in a second direction across channels of the first, second, and fourth switching devices M1, M2, M4, and functions as control electrodes of the first, second, and fourth switching devices M1, M2, M4. Here, the control electrode corresponds to a gate electrode of the transistor, and the second direction indicates a horizontal direction in FIG. 5.
The second scan line Sn-2 extends across the channel of the third switching device M3, and functions as the control electrode of the third switching device M3.
The first power source line VDD extends in the first direction, which is the same as the extending direction of the data line Dm-1, in a pixel portion including nxm pixels. The first power source line VDD supplies first power voltage to each pixel circuit 601. In FIG. 5, the first power source line VDD is coupled to a first electrode of the first capacitor Cst and a first electrode of the driving transistor MD. In this figure, a label "VDD" indicates a first power source line, but can also indicate hereinafter a first power voltage supplied to the first power source line.
The first power source line VDD is also coupled with a number of pixel circuits 160 adjacent to this power source line along the vertical direction of the figure and forms various current paths. The first power source line VDD has a lead-in point which is a predetermined point at which the first power source line VDD is led into the pixel portion. Because of current leakage in each current path, voltage drop increases as distance between the pixel circuit and the lead-in point increases.
The second power source line Vsus also extends in the first direction which is the direction of the data line Dm-1. The second power source line Vsus is coupled to a first electrode of the second switching device M2. Unlike the first power source line VDD, the second power source line Vsus does not form a current path, so there is no voltage drop due to distance from the lead-in point or due to current leakage. In this figure a reference to "Vsus" indicates a second power source line. However, it can also indicate hereinafter a second power voltage supplied to the second power source line.
Thus, according to the embodiment described above, voltage supplied to each pixel 601 of the light emitting display is compensated and substantially equalized by the application of the second power voltage Vsus so that the first capacitor Cst can be charged with a desired voltage to maintain the voltage applied to the gate electrode of the driving transistor MD. Therefore, desired current is supplied to the organic light emitting diode OLED through the driving transistor MD, enhancing the uniformity of the brightness.

A data driver (not shown) is coupled to the data lines Dm-1 and Dm, and a scan driver (not shown) is coupled to the scan lines Sn-2, Sn-1. The data driver and/or the scan driver are electrically coupled to the pixel portion that includes the plurality of pixels 601 arranged in the nxm matrix shape. The data driver and the scan driver may be formed on a chip mounted on a tape carrier package (TCP) that is attached and electrically coupled to the pixel portion. Alternatively, the data driver and/or the scan driver may be formed as a chip or the like mounted on a flexible printed circuit (FPC) or a film that is attached and electrically coupled to the pixel portion. Further, the data driver and/or the scan driver may be directly mounted on a glass substrate of the pixel portion, or substituted by a driving circuit formed on the same layer of the glass substrate as the thin film transistors of the pixel circuits 106, the data line Dm and the scan line Sn.

In the foregoing embodiment, the data line Dm, the first power source line VDD, the second power source line Vsus and the scan line Sn extend in the first or the second directions. The data line Dm, the first power source line VDD, the second power source line Vsus and the scan line Sn may have a predetermined curved or zigzag shape instead of being shaped as a straight line.

FIG. 6 is a cross-sectional view of the organic light emitting display OLED, taken along line VI-VI of FIG. 5. FIG. 6 illustrates the cross-sectional structure of one pixel 601 provided in the pixel portion of the light emitting display of the first embodiment. The cross-sectional structure includes an insulating substrate 41, such as a glass substrate, and a buffer layer 42 that may be a nitride layer, an oxide layer, or the like. The buffer layer 42 is formed to prevent impurities such as metal ions from being contaminated by an active channel of a semiconductor layer. The buffer layer 42 can be formed by chemical vapor deposition (CVD), sputtering, or similar processes.

An amorphous silicon layer is formed on the buffer layer 42, that is in turn formed on the insulating substrate 41, through CVD, sputtering, or similar processes, and annealed at a temperature of about 430°C to dehydrogenate the amorphous silicon layer. Then, the dehydrogenated amorphous silicon layer is crystallized thus forming a first electrode 43a of the second capacitor Cvth and a semiconductor layer.

Methods of crystallizing the deposited amorphous silicon layer include solid phase crystallization (SPC), excimer laser crystallization (ELC), excimer laser anneal (ELA), sequential lateral solidification (SLS), metal induced crystallization (MIC), metal induced lateral crystallization (MILC), and the like.

A gate insulating layer 44 is formed over the entire area of the insulating substrate 41 that is covered by the buffer layer 42. A first metal layer is formed by depositing a metal such as aluminum or the like on the entire area of the gate insulating layer 44. This first metal layer is patterned to form a second electrode 45b of the first capacitor Cst and a gate electrode 45a of the driving transistor MD. Thereafter, predetermined impurities are injected using the gate electrode 45a as a mask, forming a source 43c and a drain 43a of the driving transistor MD, and a drain 43d of the first switching device M1. A region of the semiconductor layer formed under the gate insulating layer across the gate insulating layer 44 is used as a channel 43b.

An interinsulating layer 46 is formed on the foregoing structure, and contact holes are formed in the interinsulating layer 46 to expose the source 43c, the drains 43a and 43d, and the first electrode 43e of the first capacitor Cst. Then, a second metal layer 47 is formed over the entire area of the foregoing structure and patterned to form a source electrode 47b and a drain electrode 47a of the driving transistor MD, and a drain electrode 47c of the first switching device (refer to FIG. 5). Here, the source electrode and the drain electrode are coupled to the source 43c and the drain 43a through the contact holes, respectively. Further, the first electrode 43e of the first capacitor Cst is coupled to the second metal layer 47 through a contact hole.

Next, a passivation layer 48 is formed on the second metal layer 47. The passivation layer 48 is formed with a contact hole to expose the drain electrode 47c. Then, an anode electrode 49 is deposited on a predetermined region of the passivation layer 48, and patterned. The anode electrode 49 is electrically coupled to the drain electrode 47c through the contact hole.

Then, a planarization layer 50 made from insulating material is formed over the foregoing structure, and patterned. The planarization layer 50 is formed with an aperture through which the anode electrode 49 is exposed and an organic emission material 51 is applied to the aperture. Last, a cathode electrode 52 is formed on the foregoing structure including the organic emission material 51.

With this structure, the driving transistor MD, the first capacitor Cst, and the organic light emitting diode are formed.

In the embodiment described above, the thin film transistor has a p-type channel. However, the structure may include a thin film transistor having an n-type channel, or having both p-type channel and n-type channels.

Further, while in this embodiment the first electrode 43e and the second electrode 45b of the first capacitor Cst are formed at the same time when the semiconductor layer 43a, 43b, 43c, 43d and the gate electrode 45a are formed, the invention is not limited to this order of depositing the layers. For example, the first capacitor Cst may include a first electrode formed on the same layer as the gate electrode 45a and a second electrode formed on the same layer as the source electrode 43c or the drain electrode 43a, 43d.

Also, in the above-described embodiment, the amorphous silicon is deposited and then crystallized in to poly silicon, thereby forming the semiconductor layer 43a, 43b, 43c, 43d, but the invention is not so limited. Alternatively, the poly silicon may be directly formed on the buffer layer 42 and patterned to form the semiconductor layer 43a, 43b, 43c, 43d.

FIG. 7 is a circuit diagram of the organic light emitting display according to the first embodiment of the present invention. For the convenience of description, a pixel circuit 601 coupled to the $m^{th}$ data line Dm and the $n^{th}$ scan line Sn will be described by way of example. Further, let a current scan line indicate a scan line to which a selection signal is currently transmitted, and let a previous scan line indicate a scan line to which a selection signal is transmitted previous to the current selection signal. In an alternative terminology, a first scan line Sn-1 is the previous scan line and a second scan line Sn is the current scan line.

The pixel circuit 601 includes the driving transistor MD, the first and second capacitors Cst, Cvth, the first through fourth transistors M1, M2, M3, M4, and the organic light emitting diode OLED.

The driving transistor MD includes the first electrode coupled to the first power source line VDD, and the second electrode coupled to the first electrode of the fourth transistor M4. The driving transistor MD is used as a static power source to supply static current to the organic light emitting diode OLED corresponding to the voltage applied to the gate of the driving transistor MD for a substantial predetermined period.

The first capacitor Cst includes a first electrode coupled to the first power source line VDD. Here, the first capacitor Cst stores first voltage corresponding to difference between the first power voltage VDD and the data voltage Vdata applied to the data line Dm.

The second capacitor Cvth is coupled between the gate of the driving transistor MD and the second electrode of the first capacitor Cst. The second capacitor Cvth stores second voltage corresponding to difference between the second power voltage Vsus and the threshold voltage of the driving transistor MD. The label "VDD" indicates both the first power source line and the first power voltage applied to this line. Similarly, the label "Vsus" indicates both the second power source line and the second power voltage applied to this line.

The first transistor M1 is coupled between the second electrode and the gate of the driving transistor MD. The first transistor M1 causes the driving transistor MD to have a diode-like connection in response to a first selection signal applied to the previous scan line or the first scan line Sn-1.

The second transistor M2 is coupled between the second power source line Vsus and the second electrode of the first capacitor Cst. The second transistor M2 carries the second power voltage Vsus to a node A in response to the first selection signal transmitted to the first scan line Sn-1. The node A is formed by coupling the second transistor M2 to the second electrode of the first capacitor Cst.

The third transistor M3 is coupled between the data line Dm and the second electrode of the first capacitor Cst. The third transistor M3 controls the data voltage Vdata that is supplied to the node A in response to a second selection signal Vsus.

The fourth transistor M4 is coupled to the second electrode of the driving transistor MD and to an anode of the organic light emitting diode OLED. The fourth transistor M4 controls the current being supplied from the driving transistor MD to the organic light emitting diode OLED in response to a selection signal transmitted to the first scan line Sn-1. In other words, the fourth transistor M4 interrupts the current flowing from the second electrode of the driving transistor MD to the organic light emitting diode OLED in response to the first selection signal transmitted to the first scan line Sn-1. In order to do so, the channel type of the fourth transistor M4 is different from the channel type of the first and second transistors M1, M2. For example, as shown in FIG. 7, the first and second transistors M1, M2 are formed of a PMOS type transistor, and the fourth transistor M4 may be formed of an NMOS type transistor.

The organic light emitting diode OLED emits light corresponding to input current. According to the first embodiment of the present invention, voltage VSS applied to a cathode of the organic light emitting diode OLED is lower than the first power voltage VDD. For example, voltage VSS may include ground voltage.

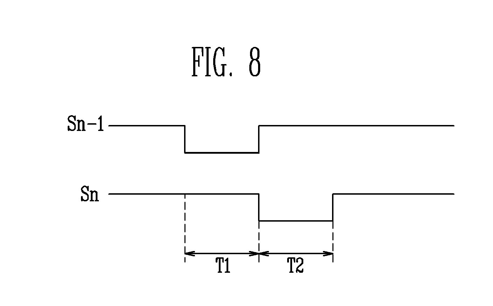

FIG. 8 illustrates waveforms for driving a pixel circuit of FIG. 7. For a period of T1, when a scan voltage having a low level is applied to the first scan line Sn-1, the first transistor M1 is turned on, and the driving transistor MD has a diode-like connection. Therefore, the voltage existing between the gate and the source (Vgs) of the driving transistor MD is changed into the threshold voltage Vth of the driving transistor MD. At this time, the first power voltage VDD is applied to the source of the driving transistor MD, so that the voltage applied to the gate of the driving transistor MD, i.e., to the first electrode of the second capacitor Cvth is equal to the sum of the first power voltage VDD and the threshold voltage Vth of the driving transistor MD.

Further, during the period of T1, when the scan voltage having a low level is applied to the first scan line Sn-1, the second transistor M2 is turned on and the second power voltage Vsus is applied to the second electrode of the second capacitor Cvth. Therefore, voltage applied between the opposite electrodes of the second capacitor Cvth, going from the first electrode to the second electrode, is calculated by the following equation 3.

[equation 3]

$$\mathrm{Vcvth} = (\mathrm{VDD} - \mathrm{Vth})$$

For the duration of the period T1, the fourth transistor M4 having the N-type channel is turned off, so that current is prevented from flowing from the driving transistor MD to the organic light emitting diode OLED. Also, the scan voltage having a high level is applied to the current or second scan line Sn, thereby turning off the third transistor M3.

Then, during a period of T2, when a scan voltage having a low level is applied to the second scan line Sn, the third transistor M3 is turned on and thus the data voltage Vdata of the data line Dm is applied to the second electrode of the second capacitor Cvth. As a result, the voltage applied between the opposite electrodes of the second capacitor Cvth is calculated by the following equation 4.

[equation 4]

$$\mathrm{Vcvth} = (\mathrm{Vsus} - \mathrm{Vdata}) - (\mathrm{VDD} - \mathrm{Vth})$$

Where Vcvth is a voltage applied between the opposite electrodes of the second capacitor Cvth; VDD is a first power voltage; Vsus is a second power voltage; Vdata is data voltage; and Vth is the threshold voltage of the driving transistor MD.

Also, during the period of T2, when the scan voltage having a low level is applied to the second scan line Sn and the third transistor M3 is turned on, the data voltage Vdata of the data line Dm is applied to the second electrode of the first capacitor Cst. Therefore, the first capacitor Cst is charged with a first voltage corresponding to a difference between the first power voltage VDD and the data voltage Vdata. Further, the second capacitor Cvth is charged with a second voltage corresponding to the sum of the second power voltage Vsus and voltage obtained by subtracting the threshold voltage Vth of the driving transistor MD from the first power voltage VDD. Therefore, a third voltage corresponding to the sum of the data voltage Vdata and the second voltage Vsus is applied to the gate of the driving transistor MD. The voltage applied between the gate and the source of the driving transistor MD is calculated by the following equation 5.

[equation 5]

$$
\begin{aligned}
\mathrm{Vgs} \quad &= \mathrm{VDD} - \mathrm{Vcvth} \\
&= \mathrm{VDD} - ((\mathrm{Vsus} - \mathrm{Vdata}) - (\mathrm{VDD} - \mathrm{Vth})) \\
&= \mathrm{Vdata} + \mathrm{Vth} - \mathrm{Vsus}
\end{aligned}
$$

Where Vgs is the voltage applied between the gate and the source electrodes of the driving transistor MD; VDD is the first power voltage; Cvth is the voltage applied between the opposite electrodes of the second capacitor; Vsus is the second power voltage; Vdata is the data voltage; and Vth is the threshold voltage of the driving transistor MD.

Referring to equation 5, to operate the driving transistor MD, the absolute value obtained by subtracting the second power voltage Vsus from the sum of the data voltage Vdata and the threshold voltage Vth of the driving transistor MD should be larger than the absolute threshold voltage Vth of the driving transistor MD.

On the basis of the equation 5, the current flowing in the organic light emitting device is calculated by the following equation 6.

[equation 6]

$$
I_{OLED} = \frac{\beta}{2}\left(Vgs - Vth\right)^2 = \frac{\beta}{2}\left((Vdata + Vth - Vsus) - Vth\right)^2 = \frac{\beta}{2}\left(Vdata - Vsus\right)^2
$$

Referring to equation 6, the current flowing in the organic light emitting diode OLED is not affected by the first power voltage VDD, so that brightness difference due to voltage drop in the first power source line VDD is compensated. Here, the second power voltage Vsus is used as compensation voltage.

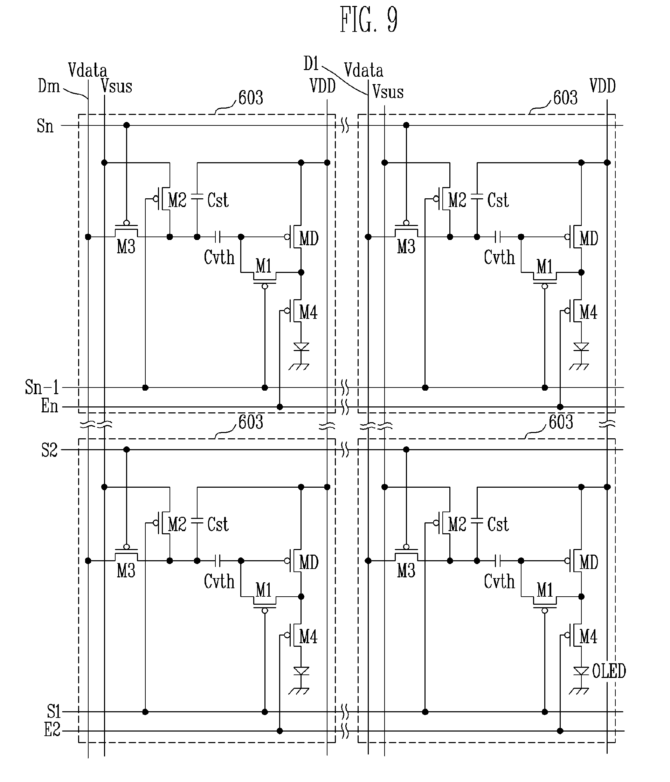

FIG. 9 is a circuit diagram of an organic light emitting display according to a second embodiment of the present invention. For convenience of description, a pixel circuit coupled to the $m^{th}$ data line Dm and the $n^{th}$ scan line Sn will be described by way of example.

The pixel circuit 603 of the light emitting display according to the second embodiment is different from that according to the first embodiment in controlling a fourth transistor M4 through a separate signal line En. When the fourth transistor M4 is controlled through the separate signal line En, the fourth transistor M4 may have a p-type or an n-type channel without affecting the circuit. Also, in this case, an emission period of the pixel circuit 603 can be controlled independently of a selection period of the first scan line Sn-1.

Thus, according to this second embodiment, variation between the first power voltages VDD supplied to the respective pixels 603 due to voltage drop is compensated using the second power voltage Vsus. Particularly, the second power source line Vsus is extended in parallel with the data line and perpendicular to the scan line, so that the compensation voltage Vsus is individually supplied to the respective pixels 603 located along a line selected by the selection signal of the scan line. Therefore, the voltage drop is prevented in the second power source line Vsus. This results in uniform brightness regardless of the position of the pixel 603.

The first through fourth transistors M1, M2, M3, M4 may be realized by p-type or n-type transistors. Alternatively, the first through fourth transistors M1, M2, M3, M4 may be realized by a switching device that performs a switching operation in response to the selection signal. The first through fourth transistors M1, M2, M3, M4 may be realized by a thin film transistor using gate, drain, and source electrodes as the control, first, and second electrodes, formed on a glass substrate of the pixel portion.

Although exemplary embodiments of the present invention have been shown and described, it would be appreciated by those skilled in the art that changes might be made in this embodiment without departing from the principles and spirit of the invention, the scope of which is defined in the claims and their equivalents.

**Claims**

1. A light emitting diode display comprising:

   a plurality of pixels;
   a plurality of data lines extending along a first direction for supplying a data signal to the plurality of pixels;
   a plurality of scan lines extending along a second direction for supplying a selection signal to the plurality of pixels, the second direction intersecting the first direction;
   a first power source line for supplying a first voltage to the plurality of pixels; and
   a second power source line extending along the first direction for supplying a second voltage to the plurality of pixels.

2. The light emitting diode display according to claim 1, wherein the second voltage compensates a voltage drop along the first power source line.

3. The light emitting diode display according to claim 1, wherein each of the plurality of pixels comprises:

   a driving transistor having a first electrode coupled to the first power source line and a second electrode coupled to a light emitting device;
   a first capacitor having a first electrode coupled to the first power source line;
   a second capacitor coupled between a gate of the driving transistor and a second electrode of the first capacitor;
   a first switching device coupled between the second electrode of the second capacitor and the gate of the driving transistor;
   a second switching device coupled between the second power source line and the second electrode of the first capacitor; and
   a third switching device coupled between the data line and the second electrode of the first capacitor.

4. The light emitting diode display according to claim 3, wherein each of the plurality of pixels further comprises a fourth switching device coupled between the second electrode of the driving transistor and the light emitting device.

5. The light emitting diode display according to claim 4, wherein each of the first switching device, the second switching device, and the fourth switching device has a control electrode coupled to a first scan line, and the third switching device has a control electrode coupled to a second scan line.

6. The light emitting diode display according to claim 5, wherein the first switching device and the second switching device include transistors of a first channel type and the fourth switching device includes a transistor of a second channel type, the second channel type being different from the first channel type.

7. The light emitting diode display according to claim 5, wherein a first selection signal supplied through the first scan line is substantially equal to a second selection signal supplied through the second scan line.

8. The light emitting diode display according to claim 4, wherein each of the first switching device and the second switching device has a control electrode coupled to the first scan line, the third switching device has a control electrode coupled to the second scan line, and the fourth switching device has a control electrode coupled to a third scan line

9. The light emitting diode display according to claim 8, wherein a third selection signal is supplied to the fourth switching device through the third scan line, a first selection signal is supplied to the first switching device and the second switching device, and a second selection signal is supplied to the third switching device.

10. The light emitting diode display according to claim 8, wherein the first switching device, the second switching device, and the fourth switching device include transistors of a same channel type.

11. The light emitting diode display according to claim 1, wherein the first power source line extends either along the first direction or along the second direction.

12. The light emitting diode display according to claim 1, wherein the second power source line is used for supplying the second voltage to each of the plurality of pixels located along the second direction selected by the selection signal.

13. The light emitting diode display according to claim 1, wherein the second voltage is substantially equal to the first voltage.

14. A light emitting diode display comprising:

    a data line extending along a first direction for carrying a data voltage;
    a first scan line and a second scan line extending along a second direction for carrying a first selection signal and a second selection signal and for applying a scan voltage, the second direction intersecting the first direction;
    a driving power source line extending along the first direction for carrying a driving power voltage;
    a compensation power source line extending along the first direction for carrying a compensation voltage;
    a pixel coupled with the data line, the first scan line, the second scan line, the driving power source line, and the compensation power source line, wherein the pixel includes:

        a light emitting device;
        a driving transistor for supplying a current corresponding to a voltage applied to a gate of the driving transistor to the light emitting device;
        a first capacitor for storing a first capacitor voltage corresponding to a difference between the driving power voltage and the data voltage;
        a second capacitor for storing a second capacitor voltage corresponding to a difference between a threshold voltage of the driving transistor and the compensation voltage;
        a first switching device for coupling the gate and a source of the driving transistor in a diode-like connection in response to the first selection signal;
        a second switching device for supplying the compensation voltage to a first electrode of the first capacitor in response to the first selection signal; and
        a third switching device for supplying the data voltage to the first electrode of the first capacitor in response to the second selection signal.

15. The light emitting diode display according to claim 14, further comprising a fourth switching device for transmitting an output from the driving transistor to the light emitting device.

16. The light emitting diode display according to claim 15, wherein the fourth switching device has a control electrode coupled to the first scan line.

17. The light emitting diode display according to claim 15, wherein the fourth switching device has a control electrode coupled to a third scan line.

18. The light emitting diode display according to claim 17, wherein a third selection signal is supplied to the fourth switching device through the third scan line while the first selection signal is supplied to the first switching device and the second switching device and the second selection signal is supplied to the third switching device.

19. The light emitting diode display according to claim 14, wherein the compensation voltage is substantially equal to the driving voltage.

# FIG. 1
## PRIOR ART

# FIG. 2
# PRIOR ART

# FIG. 3
## PRIOR ART

EP 1 612 766 A1

# FIG. 4
# PRIOR ART

15

## FIG. 5

<u>601</u>

ACTIVE LAYER

FIRST METAL LAYER

SECOND METAL LAYER

ANODE ELECTRODE

HOLE CONTACT

# FIG. 6

# FIG. 7

# FIG. 8

## FIG. 9

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 2004/070557 A1 (ASANO MITSURU ET AL) 15 April 2004 (2004-04-15) * paragraphs [0059], [0060], [0065], [0067], [0080], [0092], [0093], [0095]; figures 1,5,8 * | 1-19 | G09G3/32 |
| P,X | EP 1 536 405 A (SAMSUNG SDI CO., LTD) 1 June 2005 (2005-06-01) * paragraphs [0063] - [0071]; figures 9A-9D * | 1,2,5, 11-13 | |

----- 

TECHNICAL FIELDS SEARCHED (Int.Cl.7)

G09G

The present search report has been drawn up for all claims

| Place of search | Date of completion of the search | Examiner |
|---|---|---|
| The Hague | 31 October 2005 | Fanning, C |

EP 1 612 766 A1

## ANNEX TO THE EUROPEAN SEARCH REPORT
## ON EUROPEAN PATENT APPLICATION NO.

EP 05 10 5799

This annex lists the patent family members relating to the patent documents cited in the above-mentioned European search report.
The members are as contained in the European Patent Office EDP file on
The European Patent Office is in no way liable for these particulars which are merely given for the purpose of information.

31-10-2005

| Patent document cited in search report | | Publication date | Patent family member(s) | | Publication date |
|---|---|---|---|---|---|
| US 2004070557 | A1 | 15-04-2004 | JP | 2004133240 A | 30-04-2004 |
| EP 1536405 | A | 01-06-2005 | CN | 1622168 A | 01-06-2005 |
| | | | JP | 2005157244 A | 16-06-2005 |
| | | | US | 2005140600 A1 | 30-06-2005 |

For more details about this annex : see Official Journal of the European Patent Office, No. 12/82

EPO FORM P0459

22